Europäisches Patentamt

European Patent Office

Office européen des brevets

(19)

(11) Publication number: **0 117 365**
**B1**

(12) **EUROPEAN PATENT SPECIFICATION**

(45) Date of publication of patent specification: **27.07.88**

(51) Int. Cl.⁴: **H 01 J 37/30**

(21) Application number: **83307978.3**

(22) Date of filing: **23.12.83**

(54) Electron beam exposure apparatus.

(30) Priority: **29.12.82 JP 233763/82**

(43) Date of publication of application:
**05.09.84 Bulletin 84/36**

(45) Publication of the grant of the patent:
**27.07.88 Bulletin 88/30**

(84) Designated Contracting States:
**DE FR GB**

(56) References cited:
**EP-A-0 002 957**
**EP-A-0 025 578**
**EP-A-0 047 104**
**EP-A-0 097 016**
**DE-A-2 847 369**
**DE-A-3 206 374**
**US-A-4 130 761**
**US-A-4 189 641**

(73) Proprietor: **FUJITSU LIMITED**
**1015, Kamikodanaka Nakahara-ku**
**Kawasaki-shi Kanagawa 211 (JP)**

(72) Inventor: **Yasutake, Nobuyuki Yoshimura**
**Haitsu 201, 4-1-7**
**Utsukushigaoka Midori-ku**
**Yokohama-shi Kanagawa 227 (JP)**
Inventor: **Yasuda, Hiroshi**
**1505-1, Futoo-cho Kohoku-Ku**
**Yokohama-shi Kanagawa 222 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

The present invention relates to an electron beam exposure apparatus and more particularly to a deflection control circuit of an electron beam exposure apparatus.

Conventionally, various types of electron beam exposure apparatus have been proposed, and an electron beam exposure apparatus in which a sample can be exposed, via a rectangular aperture, by an electron beam having a rectangular section has been conventionally used.

Further, there is used a deflection system in an electron beam exposure apparatus which uses an electromagnetic-type deflector and an electrostatic-type deflector and in which the deflection range is divided so that the electron beam is deflected by a small amplitude and a large amplitude, with the result that the exposure time is shortened and a high-accuracy electron beam exposure can be carried out.

In particular, there is known from DE—A—3 206 374 an electron beam exposure apparatus according to the pre-characterising portion of claim 1.

In such an apparatus, the time required for scanning the electromagnetic-type deflector is much longer than the time required for scanning the electrostatic-type deflector and the waiting time in the electromagnetic-type deflector is from 50 to 100 us, with the result that high-speed electron exposure cannot be carried out.

EP—A—0 097 016 discloses an electron beam exposure apparatus and method in which a positioning error of the electron beam is detected prior to normal operation by a knife-edge gauge and used to produce a fixed compensation signal applied to the electron beam deflectors. This document constitutes prior art for the present application under Article 54(3) EPC only.

EP—A—0 025 578 discloses an apparatus and method for controlling a magnetic deflection system having a deflection coil and dual control means for controlling an electron beam deflection. For maintaining a steady beam deflection, the current in the deflection coil is measured to provide a "static" correction applied to the deflection coil, and for rapid changes of the beam position, the magnetic field itself is measured to provide a "dynamic" correction applied either to the deflection coil or to an additional deflection coil.

According to the present invention there is provided an electron beam exposure apparatus comprising first and second deflectors for deflecting an electron beam, the first deflector being an electromagnetic deflector and the second deflector being an electrostatic deflector, the first deflector comprising a deflection coil arranged to be energised to a level dependent on a specified value, representing a desired position of the beam, supplied by a desired value setting means, characterised by:

a monitoring resistor connected to said deflection coil and operable to provide a monitor signal monitoring an actual energisation level of the deflection coil and indicating an actual position of the beam;

comparing means coupled to the desired value setting means and the monitoring resistor, operable to compare the monitor signal and a signal indicating the specified value to produce an error signal representing the error in the energisation level of the deflection coil; and

compensating means connected to receive the error signal and operable continuously to supply only to the second deflector a correcting signal, derived in dependence upon the error signal, which will compensate for the error in the energisation level of the deflection coil thereby to correct rapidly the position of the beam to the desired position.

An embodiment of the present invention can provide an electron beam exposure apparatus which can carry out high-speed operation.

An embodiment of the present invention can provide an electron beam exposure apparatus in which the waiting time of the electromagnetic-type deflector is shortened.

These features can be achieved by providing an electron beam exposure apparatus comprising a first deflection means which deflects an electron beam based on a signal for specifying the exposure region of the sample, a second deflection means which deflects the electron beam in a desired portion in the exposure region, and means for compensating the deflection amount of the electron beam in the second deflection means in accordance with the error component of the value of the current of the deflection signal in the first deflection means.

Further features and advantages of the present invention will be apparent from the ensuing description, with reference to the accompanying drawings, to which, however, the scope of the invention is in no way limited.

Figure 1 is a plan view of a sample showing the method for exposing an electron beam in a conventional electron beam exposure apparatus.

Figure 2 is a system diagram of the deflection control device in the conventional electron beam exposure apparatus of Fig. 1.

Figure 3 is a diagram showing the rise time in the output amplifier in the deflection system of Fig. 2.

Figure 4 is a system diagram of the deflection control system in the electron beam exposure apparatus according to the present invention.

Figure 5A, 5B, and 5C are waveforms in the essential portion of the deflection control system shown in Fig. 4.

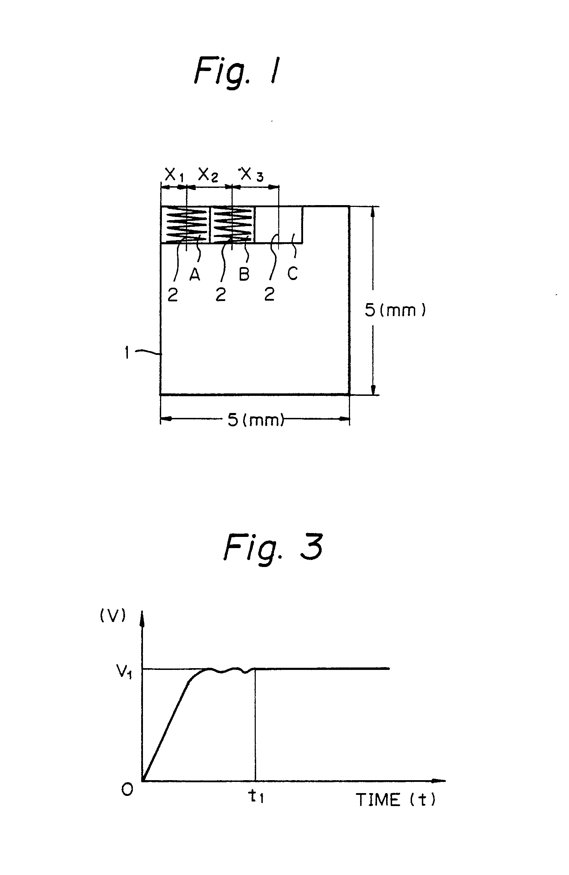

In a conventional electron beam exposure apparatus, as is shown in Fig. 1, a chip 1 having dimensions of 5×5 mm (main field) is placed on and is fixed to a mount of the electron beam exposure apparatus. Next, the electron beam is deflected over small regions A, B, C, ..., having, for example, an area of 100 μm×100 μm (so-called subfields) along the X axis direction. A computer designates the settling time as 20 μs

and the intervals between the center lines 2 of the small regions as $x_1 = 50$ μm, $x_2 = x_3$, ... 100 μm. In the above-mentioned condition, if the amplifier of the electrostatic-type deflector designates that the settling time is 100 ns at an interval of 0.05 μm, exposure of the sample can be carried out at a high speed and a high accuracy. Such electron beam exposure apparatus and the construction of its deflection control apparatus will be explained next.

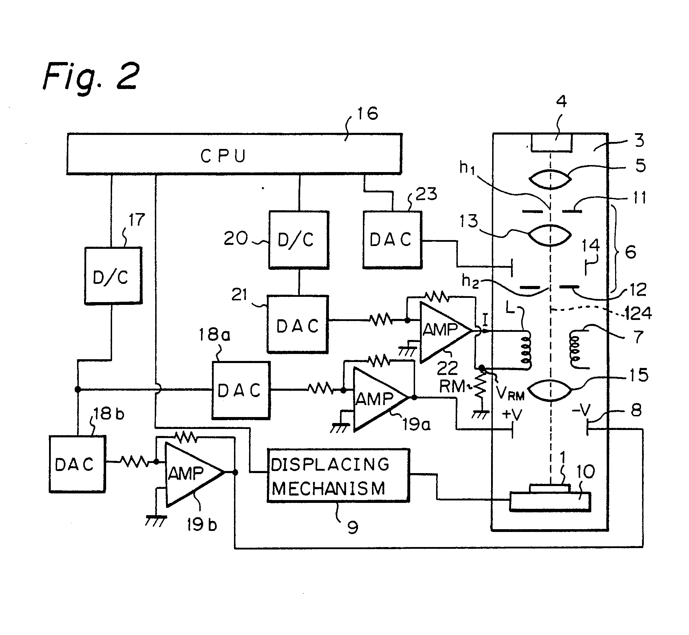

Figure 2 shows an electron beam exposure apparatus and a deflection control apparatus. The electron beam exposure apparatus 3 is composed of an electron gun 4, a focussing lens 5 for focussing the electrons generated from the electron gun 4, a changing means 6 for changing the rectangular form of the electron beam, an electromagnetic-type deflector 7 for selecting the center position of the subfields A, B, C, ..., an electrostatic-type deflector 8 for scanning the subfields, a displacing mechanism 9, and a mount 10 on which the sample 1 which is displaced in the X Y axis direction by the displacing mechanism 9 is mounted.

The changing means 6 for changing the rectangular form of the electron beam is formed, for example, from an electron lens 13 and a deflector 14 for forming an electron beam, the elements 13 and 14 being arranged between slits 11 and 12 in which rectangular apertures $h_1$ and $h_2$ are provided. Reference numeral 15 is a lens for projecting an electron beam 124 having a rectangular section which is obtained from the changing means for changing the rectangular form of the electron beam on the sample 1.

Reference numeral 16 designates a computer. The electron beam exposure apparatus is controlled by a program which stores the desired circuit pattern, and the data of the computer 16 is supplied via a digital control circuit 17, digital-analog converters 18a, 18b (hereinafter referred to as DAC), and amplifiers 19a, 19b to the electrostatic-type deflector 8 as a voltage which is proportional to the amount of deflection.

The data of the computer 16 is also supplied via a digital control circuit 20, a DAC 21, and an amplifier 22 to the electromagnetic-type deflector 7. In the drawing, only one, for example, the X axis direction, circuit arrangement is shown. However, it should be understood that the same control circuit is provided for the electromagnetic-type deflector and the electrostatic-type deflector in the Y axis direction. Further, the displacing mechanism 9, the electron beam-forming deflector 14, etc. are controlled by the data of the computer 16. Also, only the DAC 23 is shown in the circuit for input to the electron beam-forming deflector 14. However, it should be understood that another digital control circuit, another amplifier, etc. are also necessary. These elements are omitted in the drawing because they are well known to a person skilled in the art.

A monitor resistor RM is connected between the coil L of the electromagnetic-type deflector and the ground.

When the current I flows in the coil L of the electromagnetic-type deflector 7, the electron beam 124 receives a power which is proportional to the flux generated by the current I and deflects. As the output voltage $V_{RM}$ in the monitor resistor $R_M$ corresponds to the current I, it can be said that the position of the electron beam corresponds to the output level in the monitor resistor $R_M$.

The electron beam 124 which passes through the electrostatic-type deflector receives a power which is proportional to the voltage $\pm V$ applied to the deflection plates of the electrostatic-type deflector 8 so that finally the electron beam is positioned.

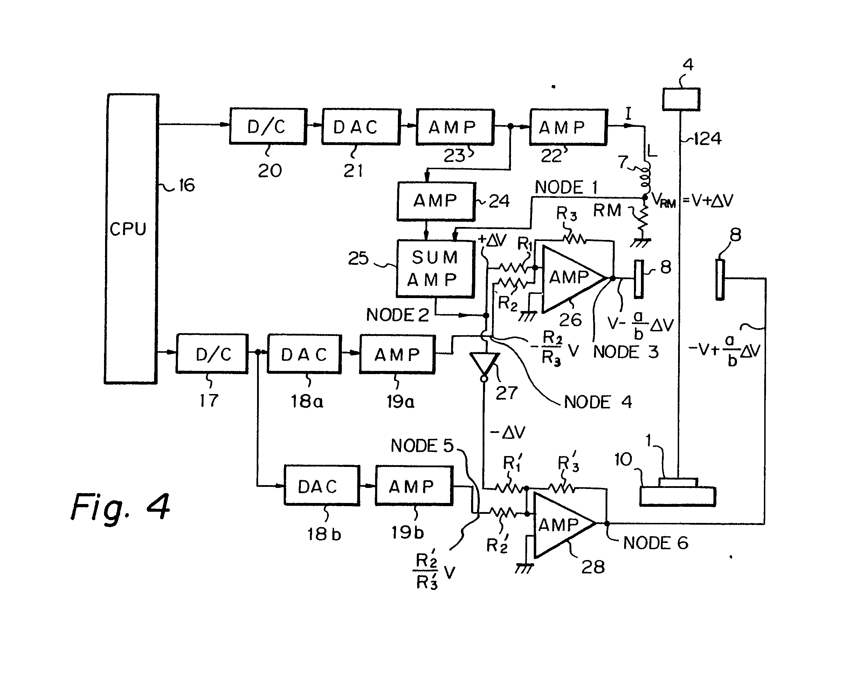

As was mentioned above, the deflections $X_1$, $X_2$, $X_3$, ... to the center of the subfields A, B, C, ... are effected by the electromagnetic-type deflector 7, and the subfields are scanned by the electromagnetic-type deflector 8 so that a pattern is formed on the sample. Therefore, when we assume that the electron beam is largely deflected, for example, from the center line 2 $(X_1)$ of the subfield A to the center line 2 $(X_2)$ of the subfield B, the relationship between the output voltage of the amplifier 22 which is proportional to the amount of deflection in the X or Y axis direction of the electron beam and the time is as is shown in Fig. 3, that is, the time $t_1$ is required so as to attain the predetermined output $V_1$. Therefore, deflection of the electrostatic-type deflector 8 cannot be carried out until the output of the amplifier 22 reaches the predetermined voltage value $V_1$, that is, the waiting time for obtaining the predetermined voltage $V_1$ becomes very long so that the high speed exposure can not be carried out.

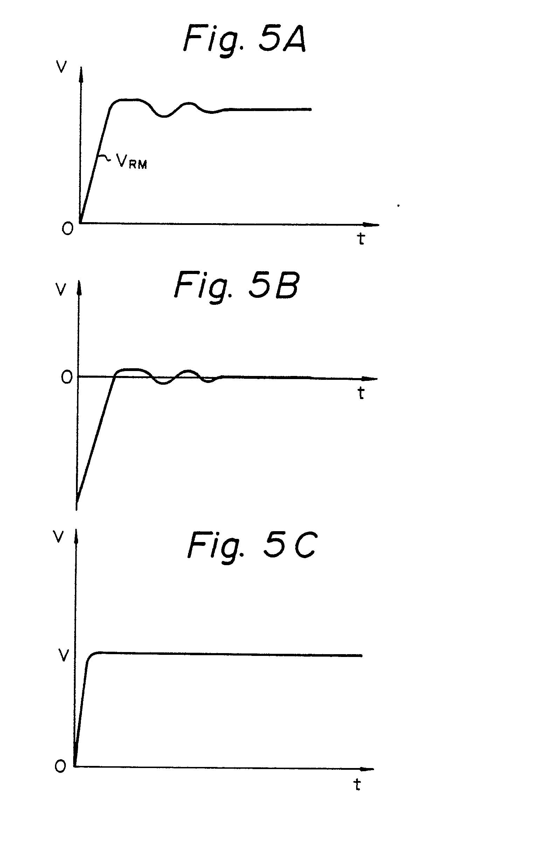

Next, one embodiment of the present invention is explained in detail with reference to Figs. 4 and 5A to 5C.

Figure 4 shows the system of the essential portion of the deflection control apparatus of the electron beam exposure apparatus according to the present invention, and Figs. 5A through 5C show the waveforms in each portion of Fig. 4. Further, in Fig. 4, the portions which are the same as those in Fig. 2 are indicated by the same symbols as in Fig. 2.

An electromagnetic-type deflector 7, that is, a first deflection system, receives data from a computer 16 via a digital control circuit 20→a DAC 21→an amplifier 23→an output amplifier 22→a coil L of the deflector 7→a monitor resistor RM→the ground→the computer 16. For example, when a value of V volts is specified to the electromagnetic deflection coil L, the beam is deflected to a value corresponding to V volts.

On the other hand, the output of the amplifier 23 is supplied to an amplifier 24, and the output of the amplifier 24 supplies a voltage $(-V)$ which is the inverted output voltage V given by the computer. Actually, if the value of the monitored output voltage in the monitor resistor RM connected to one terminal or the electromagnetic deflection coil L is $V + \Delta V$ volt, it should be understood that an error $\Delta V$ will occur in this system.

The voltage $V_{RM}$ shown as NODE 1 in the monitor resistor RM is $V_{RM}=V+\Delta V$ and has a rising waveform as is shown in Fig. 5A, and the detected voltage $V+\Delta V$ is supplied to the summing amplifier 25.

On the other hand, the output voltage $(-V)$ which is obtained by inverting the setting value V from the amplifier 24 is also supplied to the summing amplifier 25 and the error voltage $+\Delta V$ is obtained as the output of the summing amplifier 25.

This error voltage $+\Delta V$ in NODE 2 is shown in Fig. 5B.

The output of the summing amplifier 25 is supplied via a resistor $R_1$ to a first input of the output amplifier 26. A resistor $R_3$ is connected between the first input and the output of the output amplifier 26, a second input of the output amplifier 26 is connected to the ground, and the output of the output amplifier 26 is connected to one of the deflection plates of an electrostatic-type deflector 8.

On tha other hand, this deflection plate of the electrostatic-type deflector 8 receives a setting voltage V from the computer via the digital control circuit 17, the DAC 18a, the amplifier 19a, the resistor $R_2$, and the output amplifier 26.

Further, the output of the output amplifier 28 is supplied to the other deflection plate of the electrostatic-type deflector 8. The output amplifier 28 is provided with a feedback resistor $R'_3$ which is connected from the output terminal to the first input terminal, and the error voltage $+\Delta V$ from the summing amplifier 25 is inverted to $-\Delta V$, the inverted voltage $-\Delta V$ being applied to the first input of the output amplifier 28. The first input terminal also receives the setting voltage V from the computer 16 via the digital control circuit 17, the DAC 18b, the amplifier 19b, and the resistor $R'_2$. The second input terminal of the output amplifier 28 is grounded.

In the electromagnetic-type deflector, we assume that when the monitor output voltage is $\pm V$ volts, the amount of deflection (deviation) of the electron beam 124 is $\pm a$ V µm.

Further, we assume that when the voltage of the electrostatic-type deflector 8 is $\pm V$ volts, the amount of deflection (deviation) of the electron beam 124 is $\pm b$ V µm and deflection of the electron beam is $a\Delta V$ µm at the error voltage of $\Delta V$.

To cancel this error voltage, it is sufficient if the voltage $(-a/b)\Delta V$ is supplied to the electrostatic-type deflector 8 in the second deflection system. That is,

$$a\Delta V+b\times(-a/b)\Delta V=0$$

This cancellation can be effected by adjusting the conversion factor in the system from the monitor resistor RM connected to the deflection coil L of the electromagnetic-type deflector 7 in the first deflection system to the electrostatic-type deflector 8 in the second deflection system.

For example, when this cancellation is carried out by the output amplifier 26 in the electrostatic-type deflector 8, the voltage in NODE 4 (the output of the amplifier 19a) is placed to $-(R_2/R_3)V$ for the purpose of obtaining the output $V-a/b\Delta V$ in NODE 3. If the relation

$$R_3 R_1=a/b=R'_3/R'_1$$

is set, the relation

$$-\Delta V\times R_3/R_1=-a/b\Delta V$$

is established, and the error component $\Delta V$ appearing in the electromagnetic-type deflector 7 can be compensated by $(a-a/b)\Delta V$ in the electrostatic-type deflector 8. With respect to the output amplifier 28 in the electrostatic-type deflector 8, when the output value is NODE 5 is set to the value $R'_2/R'_3$, the output value $-V+(a/b)\Delta V$ can be obtained in NODE 6.

Thus, as is shown by the waveform in Fig. 5C, the error component $\Delta V$ in the electromagnetic-type deflector 7 can be compensated by the output amplifier of the electrostatic-type deflector 8. That is, in the present invention, the operation speed of the electromagnetic-type deflector 7 in the first deflection system is slow so that the operation speed of the output amplifer 22 is on the order of from several micro seconds to several tens of micro seconds while the operation speed of the electrostatic-type deflector 8 in the second deflector system is rapid, that is, on the order of hundreds of the operation speed of the electromagnetic-type deflector 7. Therefore, when the operation speed of the amplifiers 24, 25, 26, 19a, 19b, 28, etc. is set to be the same as that of the electrostatic-type deflector 8, the error of the electromagnetic-type deflector can be sufficiently compensated.

Further, considering the monitor resistor RM, the input impedance of the summing amplifier 25 must be sufficiently high.

In the above explanation, the electromagnetic-type deflector and the electrostatic-type deflector are used as the first deflection system and the second deflection system respectively. However, both the first deflection system and the second deflection system may be an electromagnetic-type deflector or an electrostatic-type deflector. For example, the error component can be compensated by supplying the error output to the deflection coil used in a scanning electron microscope attached to the electron beam exposure apparatus.

In the above-mentioned explanation, the deflection system in only the X axis direction is explained. However, actually, the axis directions of the electromagnetic-type deflector and the electrostatic-type deflector are not completely coincident. Therefore, it should be understood that the error component of the first deflection system must be allotted to the X axis and Y axis of the second deflection system.

As was mentioned in detail above, according to the present invention, the difference between the actual output of the first deflection system and the command value of the computer is detected in the summing amplifier and is supplied to the second deflection system so as to cancel the error component. Therefore, the waiting time of the scanning or the waiting time in the second deflection system which is conventionally required (from 50 to 100 µs) can be shortened to several hundred nanoseconds.

**Claims**

1. An electron beam exposure apparatus comprising first and second deflectors (7, 8) for deflecting an electron beam, the first deflector being an electromagnetic deflector and the second deflector being an electrostatic deflector, the first deflector comprising a deflection coil (7) arranged to be energised to a level dependent on a specified value, representing a desired position of the beam, supplied by a desired value setting means (16, 20, 21, 22, 23), characterised by:
a monitoring resistor (RM) connected to said deflection coil (7) and operable to provide a monitor signal monitoring an actual energisation level of the deflection coil (7) and indicating an actual position of the beam;
comparing means (25) coupled to the desired value setting means (16, 20, 21, 22, 23) and the monitoring resistor (RM), operable to compare the monitor signal and a signal indicating the specified value to produce an error signal representing the error in the energisation level of the deflection coil (7); and
compensating means (26, 28) connected to receive the error signal and operable continuously to supply only to the second deflector (8) a correcting signal, derived in dependence upon the error signal, which will compensate for the error in the energisation level of the deflection coil (7) thereby to correct rapidly the position of the beam to the desired position.

2. An electron beam exposure apparatus as claimed in claim 1, wherein the second deflector (8) comprises first and second deflection plates.

3. An electron beam exposure apparatus as claimed in claim 1 or 2, wherein the first deflector (7) is operable to deflect the electron beam to a specified exposure region of a sample, and the second deflector (8) is operable to deflect the electron beam within said specified exposure region.

4. An electron beam exposure apparatus as claimed in any preceding claim, wherein said desired value setting means comrises:
a processing unit (16) operable to supply a digital signal corresponding to the desired specified value;
a digital-analogue converter (21) operable to convert said digital signal into an analogue voltage signal; and
an amplifier (23) operable to amplify said analogue voltage signal and to supply said desired specified value.

5. An electron beam exposure apparatus as claimed in any preceding claim, wherein said comparing means comprises:
a summing or differencing amplifier (25) operable to receive said signal indicating the specified value or an inversion thereof and said monitor signal, and to supply said error signal at its output.

6. An electron beam exposure apparatus as claimed in any preceding claim, wherein said compensating means comprises:
a first output amplifier (26) operable to receive said error signal and to supply a first correcting signal, and a second output amplifier (28) operable to receive an inversion of said error signal and to supply a second correcting signal; and
wherein said second deflector comprises first and second deflecting plates (8), the first deflecting plate being connected to the output of the first output amplifier (26) and the second deflecting plate being connected to the output of the second output amplifier.

7. An electron beam exposure apparatus as claimed in claim 2, or claim 3 as appended to claim 2, wherein said desired value setting means comprises a first digital control circuit (20) operable to receive a digital signal from a computer (16), a digital-analog converter (21) connected to said digital control circuit, a first amplifier (23) connected to said digital-analog converter, a second amplifier (22) connected to said first amplifier, the deflection coil (7) of the first deflector being connected to said second amplifier; wherein there is provided a second digital control circuit (17) connected to said computer, a second digital analog converter (18a) connected to said second digital control circuit, a third amplifier (19a) connected to said second digital analog converter, a third digital analog converter (18b) connected to said second digital control circuit, and a fifth amplifier (19b) connected to said third digital analog converter; and wherein said compensating means comprises a fourth amplifier (26) connected between the output of said third amplifier and one of the deflection plates of the second deflector (8), and a sixth amplifier (28) connected between the output of said fifth amplifier and another of the deflection plates; and wherein said comparing means comprises a summing or differencing amplifier (25) having input terminals which are connected to the output of said first amplifier (23) and to said monitoring resistor (RM) and an output terminal which is connected to said fourth amplifier (26) together with ths output of said third amplifier (19a); and wherein an inverter (27) having an input terminal connected to the output of said summing amplifier and an output terminal connected to said sixth amplifier (28) together with the output of said fifth amplifier (19b), is also provided.

**Patentansprüche**

1. Elektronenbestrahlvorrichtung mit ersten und zweiten Deflektoren (7, 8), zum Ablenken eines Elektronenstrahls, wobei der erste Deflektor ein elektromagnetischer Deflektor ist und der zweite Deflektor ein elektrostatischer Deflektor ist, der erste Deflektor eine Ablenksspule (7) umfaßt, die angeordnet ist, um auf einen Pegel erregt zu werden, der von einem spezifizierten Wert abhängt, welcher eine gewünschte Position des Strahls repräsentiert, der von einer Einrichtung (16, 20, 21, 22, 23) zur Einstellung des gewünschten Wertes zugeführt wird, gekennzeichnet durch:

einen Kontrollwiderstand (RM), der mit der genannten Ablenksspule (7) verbunden ist und betreibbar ist, um ein Kontrollsignal zu liefern, welches einen tatsächlichen Erregungspegel der Ablenkspule (7) kontrolliert und eine tatsächliche Position des Strahls anzeigt;

eine Vergleichseinrichtung (25), die mit der Einstelleinrichtung (16, 20, 21, 22, 23) für den gewünschten Wert und dem Überwachungswiderstand (RM) verbunden ist und betreibbare ist, um das Kontrollsignal und ein Signal, welches den spezifizierten Wert anzeigt, zu vergleichen, um ein Fehlersignal zu erzeugen, welches den Fehler in dem Erregungspegel der Ablenksspule (7) darstellt; und

Kompensationseinrichtungen (26, 28), die angeschlossen sind, um das Fehlersignal empfangen, und kontinuierlich betreibbar sind, um lediglich an den zweiten Deflektor (8) ein Korrektursignal zu liefern, welches in Abhängigkeit von dem Fehlersignal abgeleitet ist, welches den Fehler in dem Erregungspegel der Ablenksspule (7) kompensiert, um dadurch die Position des Strahls schnell auf die gewünschte Position zu korrigieren.

2. Elektronenbestrahlvorrichtung nach Anspruch 1, bei der der zweite Deflektor (8) erste und zweite Ablenkplatten umfaßt.

3. Elektronenbestrahlvorrichtung nach Anspruch 1 oder 2, bei der der erste Deflektor (7) betreibbar ist, um den Elektronenstrahl auf einen spezifizierten Bestrahlungsbereich der Probe abzulenken, und der zweite Deflektor (8) betreibbar ist, um den Elektronenstrahl innerhalb des genannten spezifizierten Bestrahlungsbereichs abzulenken.

4. Elektronenbestrahlvorrichtung nach einem der vorhergehenden Ansprüche, bei der die Einrichtung zur Einstellung des gewünschten Wertes umfaßt:

eine Prozessoreinheit (16), die betreibbar ist, um ein digitales Signal zu liefern, welches dem gewünschten spezifizierten Wert entspricht;

einen Digital/Analog-Konverter (21), der betreibbar ist, um das genannte digitale Signal in ein Analogspannungssignal umzuwandeln; und

einen Verstärker (23), der betreibbar ist, um das genannte Analogspannungssignal zu verstärken und den gewünschten spezifizierten Wert zu liefern.

5. Elektronenbestrahlvorrichtung nach einem der vorhergehenden Ansprüche, bei der die genannte Vergleichseinrichtung umfaßt:

einen Summier- oder Differenzierverstärker (25), der betreibbar ist, um das genannte Signal, welches den spezifizierten Wert oder eine Umkehrung desselben anzeigt, und das genannte Monitorsignal zu empfangen, und um das genannte Fehlersignals an seinem Ausgang zu liefern.

6. Elektronenbestrahlvorrichtung nach einem der vorhergehenden Ansprüche, bei der die genannte Kompensationseinrichtung umfaßt:

einen ersten Ausgangsverstärker (26), der betreibbar ist, um das genannte Fehlersignal zu empfangen und ein erstes Korrektursignal zu liefern, und einen zweiten Ausgangsverstärker (28), der betreibbar ist, um eine Inversion des genannten Fehlersignals zu empfangen und eine zweites Korrektursignal zu liefern;

und bei der der genannte zweite Deflektor erste und zweite Ablenkplatten (8) umfaßt, die erste Ablenkplatte mit dem Ausgang des ersten Ausgangsverstärkers (26) verbunden ist und die zweite Ablenkplatte mit dem Ausgang des zweiten Ausgangsverstärkers verbunden ist.

7. Elektronenbestrahlvorrichtung nach Anspruch 2, oder nach Anspruch 3 in Verbindung mit Anspruch 2, bei der die Einrichtung zur Einstellung des gewünschten Wertes eine erste digitale Steuerschaltung (20) umfaßt, die betreibbar ist, um ein digitales Signal von einem Computer (16) zu empfangen, einer Digital/Analog-Konverter (21), der mit der genannten digitalen Steuerschaltung verbunden ist, einen ersten Verstärker (23), der mit dem genannten Digital/Analog-Konverter (23) verbunden ist, einen zweiten Verstärker (22), der mit dem genannten ersten Verstärker verbunden ist, wobei die Ablenkpule (7) des ersten Deflektors mit dem genannten zweiten Verstärker verbunden ist; bei welcher eine zweite digitale Steuerschaltung (17) vorgesehen ist, die mit dem genannten Computer verbunden ist, ein zweiter Digital/Analog-Konverter (18a), der mit der genannten zweiten digitalen Steuerschaltung verbunden ist, ein dritter Verstärker (19a), mit dem genannten zweiten Digital/Analog-Konverter verbunden ist, ein dritter Digital/Analog-Konverter (18b), der mit der genannten zweiten digitalen Steuerschaltung verbunden ist, und ein fünfter Verstärker (19b), der mit dem genannten dritten Digital/Analog-Konverter verbunden ist; und bei der die genannte Kompensationseinrichtung einen vierten Verstärker (26) umfaßt, der zwischen dem Ausgang des dritten Verstärkers und einer der beiden Ablenkplatten des zweiten Deflektors (8) verbunden ist, und einen sechsten Verstärker (28), der zwischen dem Ausgang des genannten fünften Verstärkers und einer anderen der Ablenkplatten verbunden ist; und bei welcher die genannte Vergleichseinrichtung einen Summier- oder Differenzverstärker (25) umfaßt, der Eingangsanschlüsse hat, welche mit dem Ausgang des genannten ersten Verstärkers (23) und mit dem genannten Überwachungswiderstand (RM) und einem Ausgangsanschluß verbunden ist, welcher mit dem genannten vierten Verstärker (26) verbunden ist, zusammen mit dem Ausgang des genannten dritten Verstärkers (19a); und bei welcher ferner ein Inverter (27) vorgesehen ist, der einen Eingangsanschluß hat, der mit dem Ausgang des genannten Summierverstärkers verbunden ist, und einen Ausgangsanschluß, der mit dem sechsten Verstärker (28) verbunden ist, zusammen mit dem Ausgang des genannten fünften Verstärkers (19b).

## Revendications

1. Appareil d'exposition à faisceau électronique comprenant un premier et un deuxième déviateur (7, 8) servant à dévier un faisceau électronique, le premier déviateur étant un déviateur électromagnétique et le deuxième déviateur étant un déviateur électrostatique, le premier déviateur comprenant une bobine de déviation (7) destinée à être excitée à un niveau qui dépend d'une valeur spécifiée, représentant la position voulue du faisceau, délivrée par un moyen (16, 20, 21, 22, 23) de fixation de la valeur voulue, caractérisé par:

une résistance de contrôle (RM) connectée à ladite bobine de déviation (7) et ayant pour fonction de fournir un signal de contrôle contrôlant le niveau d'excitation réel de la bobine de déviation (7) et indiquant la position réelle du faisceau;

un moyen de comparaison (25) couplé au moyen (16, 20, 21, 22, 23) de fixation de la valeur voulue et à la résistance de contrôle (RM), ayant pour fonction de comparer le signal de contrôle et un signal indiquant la valeur spécifiée afin de produire un signal d'erreur représentant l'erreur du niveau d'excitation de la bobine de déviation (7); et

un moyen de compensation (26, 28) connecté de façon à recevoir le signal d'erreur et ayant pour fonction de délivrer de manière continue au seul deuxième déviateur (8) un signal de correction, obtenu sur la base du signal d'erreur, lequel compensera l'erreur du niveau d'excitation de la bobine de déviation (7) afin de corriger rapidement la position du faisceau et de l'amener à la position voulue.

2. Appareil d'exposition à faisceau électronique selon la revendication 1, où le deuxième déviateur (8) comprend une première et une deuxième plaque de déviation.

3. Appareil d'exposition à faisceau électronique selon la revendication 1 ou 2, où le premier déviateur (7) a pour fonction de dévier le faisceau électronique jusqu'à une région d'exposition spécifiée d'un échantillon, et le deuxième déviateur (8) a pour fonction de dévier le faisceau électronique à l'intérieur de ladite région d'exposition spécifiée.

4. Appareil d'exposition à faisceau électronique selon l'une quelconque des revendications précédentes, où ledit moyen de fixation de la valeur voulue comprend:

une unité de traitement 6) ayant pour fonction de délivrer un signal numérique correspondant à la valeur spécifiée voulue;

un convertisseur numérique-analogique (21) ayant pour fonction de transformer ledit signal numérique en un signal de tension analogique; et

un amplificateur (23) ayant pour fonction d'amplifier ledit signal de tension analogique et de délivrer ladite valeur spécifiée voulue.

5. Appareil d'exposition à faisceau électronique selon l'une quelconque des revendications précédentes, où ledit moyen de comparaison comprend:

un amplificateur d'addition, ou de soustraction, (25) ayant pour fonction de recevoir ledit signal indiquant la valeur spécifiée, ou son opposé, et ledit signal de contrôle, et de délivrer ledit signal d'erreur à sa sortie.

6. Appareil d'exposition à faisceau électronique selon l'une quelconque des revendications précédentes, où ledit moyen de compensation comprend:

un premier amplificateur de sortie (26) ayant pour fonction de recevoir ledit signal d'erreur et de délivrer un premier signal de correction, et un deuxième amplificateur de sortie (28) ayant pour fonction de recevoir l'opposé dudit signal d'erreur et de délivrer un deuxième signal de correction;

et où ledit deuxième déviateur comprend une première et une deuxième plaque de déviation (8), la première plaque de déviation étant connectée à la sortie du premier amplificateur de sortie (26) et la deuxième plaque de déviation étant connectée à la sortie du deuxième amplificateur de sortie.

7. Appareil d'exposition à faisceau électronique selon la revendication 2, ou la revendication 3 prise en dépendance avec la revendication 2, où ledit moyen de fixation de la valeur voulue comprend un premier circuit de commande numérique (20) ayant pour fonction de recevoir un signal numérique de la part d'un calculateur (16), un convertisseur numérique-analogique (21) connecté audit circuit de commande numérique, un premier amplificateur (23) connecté audit convertisseur numérique-analogique, un deuxième amplificateur (22) connecté audit premier amplificateur, la bobine de déviation (7) du premier déviateur étant connectée audit deuxième amplificateur; où il est prévu un deuxième circuit de commande numérique (17) connecté audit calculateur, un deuxième convertisseur numérique-analogique (18a) connecté audit deuxième circuit de commande numérique, un troisième amplificateur (19a) connecté audit deuxième convertisseur numérique-analogique, un troisième convertisseur numérique-analogique (18b) connecté audit deuxième circuit de commande numérique, et un cinquième amplificateur (19b) connecté audit troisième convertisseur numérique-analogique; où ledit moyen de compensation comprend un quatrième amplificateur (26) connecté entre la sortie dudit troisième amplificateur et l'une des plaque de déviation du deuxième déviateur (8), et un sixième amplificateur (28) connecté entre la sortie dudit cinquième amplificateur et une autre des plaques de déviation; où ledit moyen de comparaison comprend un amplificateur d'addition ou de soustraction (25) possédant des bornes d'entrée qui sont connectées à la sortie dudit premier amplificateur (23) et à ladite résistance de contrôle (RM) et une borne de sortie qui est connectée audit quatrième amplificateur (26) en même temps que la sortie dudit troisième amplificateur (19a); et où un inverseur (27) possédant une borne d'entrée connectée à la sortie dudit amplificateur d'addition et une borne de sortie connectée audit sixième amplificateur (28) en même temps que la sortie dudit cinquième amplificateur (19b), est également prévu.

## Fig. 1

## Fig. 3

# Fig. 2

Fig. 4

Fig. 5A

Fig. 5B

Fig. 5C